# EUROPEAN PATENT SPECIFICATION

(11) **EP 3 462 479 B1**
(45) Date of publication and mention of the grant of the patent: **09.12.2020**
(21) Application number: 17194408.5
(22) Date of filing: 02.10.2017
(51) Int. Cl.: H01L 23/051, H01L 25/07, H01L 23/62, H03K 17/082

(54) **SEMICONDUCTOR ASSEMBLY WITH FAULT PROTECTION**
HALBLEITERANORDNUNG MIT FEHLERSCHUTZ
ENSEMBLE SEMI-CONDUCTEUR AVEC PROTECTION CONTRE LES DÉFAUTS

(43) Date of publication of application: 03.04.2019
(73) Proprietor: General Electric Technology GmbH, 5400 Baden (CH)
(72) Inventor: OUTRAM, John Lewis, Stafford, ST17 4LX (GB); GREGOIRE, Jerome, Stafford, ST17 4LX (GB)
(74) Representative: Brevalex

(56) References cited:
- WO-A1-2013/004297
- WO-A1-2015/090428
- US-A1- 2012 262 218
- US-B1- 9 355 950

## Description

The present invention relates to semiconductor assemblies, apparatus comprising such assemblies and methods of operation thereof.

### BACKGROUND OF THE INVENTION

One or more semiconductor devices may be housed within a housing to form a semiconductor assembly. The housing performs several functions, for example it protects a semiconductor device from damage due to environmental conditions such as humidity/moisture or physical impacts. Furthermore the housing may electrically isolate the device by encapsulating the device in an insulating material. Typically the housing also allows controlled electrical connection from the semiconductor device to other electrical components by providing electrical terminals connected to terminals of the semiconductor device. The housing may also function as a heatsink to dissipate excess heat created in the device, especially for semiconductor devices designed to be used in high power applications.

In some semiconductor housings, connections are made between terminals of the semiconductor device and terminals of the housing using wire bonds, where small wires are connected between the terminals of the semiconductor device and the terminals of the housing. In some housings terminals of the semiconductor device are soldered directly to terminals of the housing. In other housings the terminals of the semiconductor device are not bonded to the terminals of the housing, but are held in physical and electrical contact by applying a force to the exterior of the package.

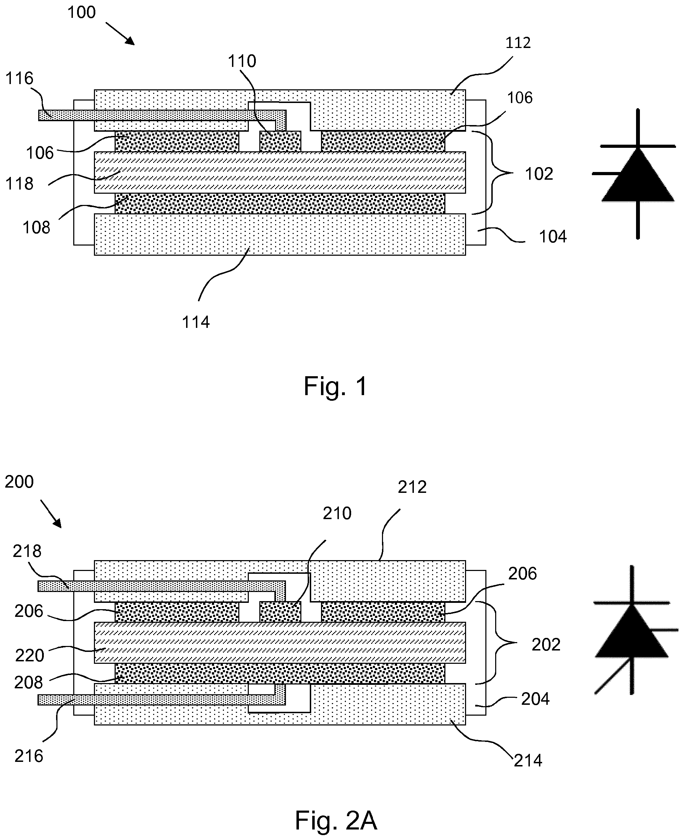

Housing for for semiconductor devices include press-pack and flat pack housings. An example of a prior art press-pack 100 is illustrated in Figure 1, which shows a cross-section of a semiconductor device 102 and a housing 104. The semiconductor device 102 comprises three terminals, two of which are terminals 106, 108 which are connected to power terminals of the housing as described below, and one of which is a control, or a gate, terminal 110. The semiconductor device 102 comprises a semiconductor material 118. The semiconductor device 102 in this example may be a semiconductor switching device, for example a power semiconductor device, such as a thyristor, a GTO (gate turn-off thyristor), an IEGT (Injection-Enhanced Gate Transistor), an IGCT (Integrated Gate-Commutated Thyristor), a transistor, an IGBT (Insulated Gate Bipolar Transistor), a TRIAC (also known as a bidirectional triode thyristor) or a MOSFET (Metal Oxide Semiconductor Field Effect Transistor). However in other examples other semiconductor devices such as diodes (which lack a gate terminal) can be used in press-packs. In this example the terminals 106, 108, 110 of the semiconductor device are connected to terminals 112, 114, 116 of the press-pack. The press-pack housing has three corresponding terminals, two power terminals 112, 114 and a control, or gate terminal 116. The power terminals 112, 114 have a significantly larger cross-sectional contact area than the gate terminal 116 so they are capable of carrying a higher current than the control/gate terminal 116. The large cross-section of the power terminals 112, 114 results in a lower resistance. Typically such a press pack 100 is assembled and clamped under high pressure to achieve good electrical contacts.

Such semiconductor assemblies may be suitable for use in high power applications, for example in converters used to change the voltage level of a power source and/or to transfer power between a Direct Current (DC) and an Alternating Current (AC). An example of a High Voltage Direct Current (HVDC) converter is a Modular Multi-Level Converter (MMC) which is a class of Voltage Source Converter (VSC) with a scalable topology that can be designed to operate at high voltages. MMCs can provide excellent harmonic performance and these advantages, combined with relative ease of timing control, have made MMCs the subject of much ongoing research and development.

An MMC VSC converter may comprise at least one (often three parallel) phase limbs, each limb comprising two valves. Each valve is made up of a plurality of submodules, each comprising an energy storage element, usually a capacitor. The submodules are arranged such that the energy storage element therein can be switched in or out of a series connection with the other energy storage elements in the valve.

In order to respond to an active and/or reactive power demand from the MMC, energy and voltage supplied by each submodule is controlled.

Semiconductor assemblies comprising semiconductor devices may be used in the control of submodules of MMCs and can be used in switching the energy storage element as described above. Semiconductor housings such as press-packs may be suitable for such uses as they are capable switching the high power energy storage elements and supporting large currents.

For economic reasons, some semiconductor devices used in the control of submodules of MMCs may be of the type where connections are made between terminals of the semiconductor device and terminals of the housing using wire bonds. The wire bonds may fail open-circuit under fault current conditions or when the semiconductor fails. For this reason, press-pack type semiconductor devices may be placed in parallel with wire-bond type semiconductor devices in order to divert fault currents and prevent the wire bonds being damaged or provide a continuity of electrical connection if the wire bonds have been damaged. Other devices are known in prior art to provide the function of providing continuity of electrical connection if the wire bonds have been damaged, such as electro-mechanical switches.

The documents US2012/262218 and WO2013/004297 disclose a semiconductor assembly according to the preamble of claim 1.

According to a first aspect of the present invention, there is provided a semiconductor assembly comprising the features of claim 1. The state change trigger terminal is connected to the semiconductor device and is configured to deliver energy to the semiconductor device to cause a change in state thereof such that a permanent conductive path is formed between the first and second terminals. For example, the change in state may be a breakdown of a semiconductor material of the semiconductor device, and/or a change in conductive state (from semiconductor to conductor). For the avoidance of doubt, 'state' as used herein is not tied to a state of matter, such as solid, liquid, gas, etc.

This allows the assembly to be 'short circuited' via the state change trigger terminal (which could alternatively be referred to as a 'permanent state change trigger terminal', or an 'irreversible state change trigger terminal'), allowing for a controlled 'shorting out' of the assembly. For example, if the assembly is in parallel with a wire-bond type semiconductor device, it may be controlled to 'short out' in order to provide electrical continuity in the event that the wire-bond type device is damaged and unable to carry the load current. By controlling the assembly to 'short out' it removes the need to provide an energy source to support ongoing gating that may otherwise be indicated in a conventional press-pack type device to ensure ongoing electrical continuity. Moreover, such an assembly may be provided in place of an electro-mechanical switch to provide continuity of electrical connection (which may have an advantage in that, in some examples set out herein, such 'shorting out' may be achieved 100 to 1000 times faster than in an electro-mechanical switch).

For example, the state change trigger terminal may be capable of delivering energy, in some examples in the form of a pulse, with sufficient power density to cause the permanent conductive path to form between the first and second power terminals. A relatively high current, or power, density may cause local heating in a semiconductor material of the semiconductor device, changing its structure and electrical characteristics, in particular causing it to break down when it would previously have blocked current by supporting voltage.

The local heating effect may be achieved, at least in part, through deliberate resistance in the energy delivery path (for example at the point of contact with the semiconductor device), reducing the current density that might otherwise be required. The resistance of the contact between the state change trigger terminal and a terminal of the semiconductor device is determined by the type of contact (for example a bonded contact or a pressure contact), the area of the contact, the pressure at the contact (where a pressure contact is used), by the presence of an interface material between the contacts and the properties of the point of contact (for example the cross sectional area or the resistivity). In some examples, the properties of the state change trigger terminal may vary along its length, for example at the point of contact it may have a different resistance or resistivity compared to in the bulk of the state change trigger terminal.

Once the semiconductor material is damaged locally, a relatively high power density from the load current passing through the small defect will cause excessive temperature in the neighbouring material causing it, in turn, to break down. The process proceeds until the current is carried by a relatively large area of the semiconductor with relatively low power density and associated low losses.

In accordance with the invention, the contact area of the connection of the state change trigger terminal with the second terminal of the semiconductor device is smaller than the contact area of the first and second power terminals with the semiconductor device. A smaller area tends to increase the current density, and therefore power density. For example, the cross sectional areas of the first and second power terminals may be at least ten times, at least 20, or at least 50 times greater than the cross sectional area of the state change trigger terminal. In other examples the cross sectional area of the first and second terminals may be many orders of magnitude larger than the cross section of the state change trigger terminal, for example 1,000 times or 100,000 times the area.

The semiconductor device may comprise a third terminal which is a gate terminal. Providing a gate terminal may provide a more versatile semiconductor assembly. In some such examples, the assembly may comprise a gate terminal connection which is electrically connected to the gate terminal of the semiconductor device. This allows the device to be switched on and in some cases switched off in a controlled manner in addition (and prior) to being permanently shorted, depending on operational requirements.

In some examples, the first terminal of the semiconductor device is a cathode, emitter or source, and the second terminal of the semiconductor device is an anode, collector or drain. This may for example result in a connection between the state change trigger terminal and the anode of the semiconductor device, which, if the semiconductor device is in anti-parallel with a transistor such as an IGBT, means the state change trigger terminal will be driven relative the IGBT emitter and therefore delivery of a pulse of energy may be facilitated.

Where a gate terminal connection is provided, the state change trigger terminal may have a larger cross sectional area (and hence a higher current rating) than the gate terminal connection. This is to allow it to deliver sufficient energy to cause the breakdown of the semiconductor material. The gate terminal may not carry any significant current, so may be smaller than the other terminals, reducing cost of materials. As noted above, in such examples, the state change trigger terminal of the housing may have a smaller cross sectional area than the power terminals of the housing. A smaller cross sectional area allows a higher power density to be delivered at the state change trigger terminal compared to the power terminals, resulting in localised heating to provide the breakdown of the semiconductor material.

In some examples, the first terminal of the semiconductor device and the gate terminal are electrically connected via connections to the first power terminal. This means that the assembly may be in a stable 'off' state until the energy is applied to the state change trigger terminal.

The semiconductor assembly may comprise a housing, the housing comprising the first power terminal; the second power terminal and the state change trigger terminal. The assembly may comprise a press-pack. As used herein the term press-pack is used to refer to any type of 'press-pack' or 'hockey puck' package. Although wire bonded semiconductor assemblies are known, faults encountered by such assemblies may result in the bonds failing, and thus they are more likely to fail to an open circuit, rather than to form a conductive path as set out herein.

The semiconductor device may for example comprise a thyristor, a GTO, an IGBT, an IEGT, an IGCT, a diode, a TRIAC, a transistor or a MOSFET.

In some examples the semiconductor assembly comprises a plurality of semiconductor devices each comprising first and second terminals, and the state change trigger terminal is connected to each semiconductor device and is configured to deliver energy to a plurality of the devices to cause a change in the state of each of the semiconductor devices to which energy is delivered such that a permanent conductive path is formed the first and second terminals thereof. The state change trigger terminal may branch out within the semiconductor assembly to connect to a plurality of semiconductor devices. On application of energy to such a state change trigger terminal, all the connected semiconductor devices (i.e. those devices connected to the state change trigger terminal) can be caused to permanently change to form a conductive path between their terminals.

In a second aspect of the invention, an apparatus is provided, the apparatus comprising a semiconductor assembly in accordance with the invention, an energy source and a controller. The semiconductor assembly comprises a state change trigger terminal and a semiconductor device. The controller is configured to detect a fault condition, and on detection of said fault condition cause the energy source to supply energy to the state change trigger terminal of the semiconductor assembly to cause a change in state thereof such that a permanent conductive path is formed between a first power terminal and second power terminal of the semiconductor device.

In some examples, the apparatus is a Modular Multi-Level Converter submodule and the energy source is an energy storage element which, in use of the submodule in a MMC, provides an energy source for synthesising a voltage. For example the energy source may comprise a capacitor. The submodule may comprise a controller, which may detect the fault. Detection of the fault may occur by the submodule controller directly detecting the fault or being signalled data from another component. In other examples the detection may be carried out by a controller which is external to the submodule.

In some examples, the apparatus further comprises a control element (for example a thyristor) to begin supply of energy to the state change trigger terminal of the semiconductor assembly and a current interruption device configured to end supply of energy to the state change trigger terminal of the semiconductor assembly, wherein the controller is configured to switch the control element to begin supply of energy; and the current interruption device is configured to interrupt the current flow once a pulse energy capable of causing the permanent conductive path to form has been delivered to the state change trigger terminal. The current interruption device may for example comprise an overcurrent protection device such as a fuse, and may operate automatically. In other examples the control element is used to turn the pulse on and off, for example an IGBT may be switched on to start a pulse and switched off to end the pulse. In other examples a control element may be used to begin supply of energy, the energy being provided by a dedicated energy source, such as a capacitor. Such a dedicated energy source may be designed to store the appropriate amount of energy required for a pulse. In such an example, the pulse will end when the energy source is discharged (and so a separate device to end the pulse may not be provided).

According to a third aspect of the invention, there is provided a method of operating a semiconductor assembly in accordance with the present invention within an apparatus comprising:
monitoring operation of the apparatus to detect a fault condition;
and, on detection of a fault condition;
delivering energy to a semiconductor material within the semiconductor assembly to cause a permanent conductive path to form through the semiconductor material. This may comprise causing a state change in the semiconductor material. The state change may for example be a change from a non-conductive to a conductive state.

In some examples, the method may comprise delivering energy as a pulse of current to heat the semiconductor material to cause a breakdown in the structure of the semiconductor material.
Embodiments of the invention are now described by way of example only with reference to the following Figures in which:
**Figure 1** is a schematic drawing of a press-pack;
**Figures 2A-C** are schematic drawings showing embodiments of semiconductor assemblies according to the present invention;
**Figure 3** shows a Modular Multi-Level Converter (MMC);
**Figure 4** shows a Modular Multi-Level Converter (MMC) submodule;
**Figures 5A-E** are examples of apparatus comprising semiconductor assemblies;
**Figure 6** is a further example of an apparatus comprising semiconductor assemblies.

Figure 1 shows an example of a prior art press-pack, and has been described above.

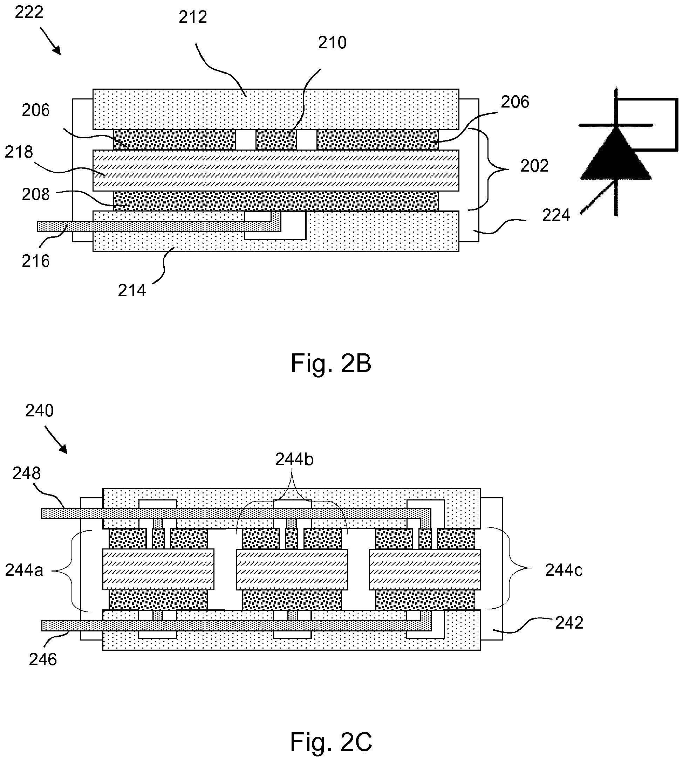

Figures 2A and 2B are embodiments of semiconductor assemblies.

Figure 2A shows a semiconductor assembly 200 in accordance with an embodiment of the invention, comprising a semiconductor device 202 and a housing 204. In this example the housing 204 is a press-pack and the semiconductor device is a thyristor. The semiconductor device 202 comprises terminals 206, 208, 210, two of which are power terminals 206, 208 and one of which is a gate terminal 210. The housing 204 comprises four terminals 212, 214, 216, 218. Two of these terminals are power terminals 212, 214, one terminal is a state change trigger terminal 216, and one terminal is a gate terminal connection 218.

In this example the power terminals 206, 208 of the semiconductor device 202 are, respectively, a cathode 206 and anode 208 of the semiconductor device 202 and are electrically connected to the power terminals 212, 214 of the press-pack housing 204. The semiconductor device 202 comprises a semiconductor material 220. In operation, before application of a state change trigger pulse, the semiconductor device 202 blocks flow of current from the cathode 206 to the anode 208 at all times and blocks flow of current from the anode 208 to the cathode 206 when the gate terminal 210 has not been triggered by a voltage (known as a bias voltage or signal) applied relative to the cathode 206. When the semiconductor device 202 is adequately forward biased from anode 208 to cathode 206 and a gate bias is applied, it will latch into a conductive state. In the conductive state the semiconductor device 202 will conduct current from anode 208 to cathode 206. The semiconductor device 202 remains in a latched conductive state until the current from the anode 208 to the cathode 206 falls below a threshold, at which point it will become non-conductive until a gate bias signal and a forward bias voltage from the anode 208 to the cathode 206 is again applied.

In this example the semiconductor device 202 is arranged in a housing 204 such that the first power terminal 206 is electrically connected to the first power terminal 212 of the housing 204 and the second power terminal of the semiconductor device 202 is electrically connected to a second power terminal 214 of the housing 204. The gate terminal connection 218 of the housing 204 is electrically connected to the gate terminal 210 of the semiconductor device 202 and therefore the semiconductor device 202 can be switched by applying a bias voltage to the gate terminal connection 218 of the housing 204. This allows the semiconductor device 202 to be used to control the flow of current between the power terminals 212, 214. The housing 204 is also provided with a state change trigger terminal 216 which is electrically connected to the second power terminal 208 of the semiconductor device 202. The electrical properties of the semiconductor device 202 may be permanently altered by application of an energy pulse to the state change trigger terminal 216 of the housing 204. On application of a sufficient energy pulse, the semiconductor material 220 is locally heated and a conductive path is permanently formed between the power terminals 206, 208.

As is shown in the embodiment of Figure 2A, the power terminals 212, 214 of the housing 204 are significantly larger than the state change trigger terminal 216. In this example the power terminals 212, 214 of the housing have a cross sectional area of at least 10 times that of the state change trigger terminal 216, or in some examples at least 100 times, at least 1,000 times, or at least 10,000 times that of the state change trigger terminal 216. In other examples the cross sectional area of the power terminals 212, 214 of the housing 204 may be many orders of magnitude larger than the cross section of the state change trigger terminal 216 of the housing 204. For example the diameter of the power terminals 212, 214 may be approximately 75mm and the diameter of the state change trigger terminal 216 may be approximately 0.1 mm.

In this example the power terminals 212, 214 are disc shaped, and the gate terminal 218 and state change trigger terminal 216 connect to the semiconductor device approximately centrally and exit through a side of the housing 204. The power terminals 212, 214 have a larger cross sectional area to allow them to carry a large current. In contrast the state change trigger terminal 216 has a relatively smaller cross sectional area. This is because it is not required to carry such a large current, and also so that the current which is delivered thereby is delivered to a relatively small region of the semiconductor device 202 and therefore the current density is high. By delivering the energy to a small region, even a relatively small amount of energy may be sufficient to cause localised heating resulting in a permanent change to the device 202. If the same energy were to be delivered to a larger region, the temperatures achieved would be lower due to the lower power density and would be insufficient to cause a permanent change in the properties of the semiconductor device 202 and/or the energy supplied would have to be higher. Therefore the state change trigger terminal 216 may be capable of carrying a higher current density, but a lower total current than the power terminals 212, 214.

In this example the semiconductor device 202 is a thyristor, which is a device with three terminals 206, 208, 210. However in other examples the device 202 may have fewer or more terminals, for example it may be a diode with two terminals.

In this example the semiconductor device 202 is primarily composed of silicon. As such, the material may become damaged such that it may form a permanent conductive path on being heated to around 300°C. In other examples the semiconductor device 202 may be primarily composed of gallium nitride, silicon carbide, or any other suitable material. Different, in some examples higher, temperatures may be required to change the conductive properties of such materials.

An example of the energy required to damage a small area of silicon can be calculated. In an example, a silicon wafer has a thickness of 1.4mm and an area of 1mm radius so the volume is 1.4×π×1² = 4.4mm³ is to be heated. Silicon has a specific heat capacity of 0.7J/gK and a density of 2.3g/cm³ so its volumetric heat capacity is 1.6J/cm³K = 1.6mJ/mm³K. Assuming a 250K temperature rise is needed to cause the silicon to breakdown, the energy required is 4.4×1.6×250 = 1760mJ = 1.8J, assuming the pulse is applied in a short period of time such that the heat does not significantly dissipate to the surrounding material on the time scale of the application of the pulse. This quantity of energy may be stored in a capacitor. For example this energy may be stored at 50 V, in a 1440µF (C = 1.8×2/50² = 1440µF) and is therefore practical to achieve with relatively small and readily available components.

In this example the gate terminal connection 218 has a smaller cross sectional contact area than the power terminals 212, 214, as there is no requirement for it to carry any significant current in supplying a bias signal. In some examples the cross sectional contact area of the state change trigger terminal 216 will be greater than the cross sectional contact area of the gate terminal 218, as the state change trigger terminal 216 carries a higher current. In other examples the state change trigger terminal 216 may be rated to carry a higher current by virtue of the materials it is constructed from. As described previously, in this example the cross sectional contact area of the state change trigger terminal 216 is smaller than that of the power terminals 212, 214.

Figure 2B shows another embodiment of a semiconductor assembly 222. The semiconductor assembly 222 comprises a semiconductor device 202, as described above. The semiconductor assembly also comprises a housing 224, which is similar to the housing 204 described above, however it does not comprise a gate terminal. In this example the gate terminal 210 of the semiconductor device 202 is connected to the first power terminal 212 of the housing 204, causing the gate terminal 210 to be short circuited to the cathode 206 of the semiconductor device 202. In this example the semiconductor device 202 is a thyristor, and the short circuit prevents the thyristor 202 from being switched to the latched conduction state by application of a gate bias. Therefore the thyristor 202, in this configuration, will block current in a circuit in both directions. As described in relation to Figure 2A, the state change trigger terminal 216 is connected to the power terminal 208 and an energy pulse may be applied to the state change trigger terminal 216 of the housing 224 to cause a permanent conductive path to form between the power terminals of the semiconductor device.

As described in relation to Figures 2A and 2B, the housing 204, 224 may provide a press-pack. In other examples the housing 204, 224 may be any type of semiconductor package or module suitable for the required application which can reliably form a short circuit. In a press-pack, the terminals of the semiconductor device 202 are engaged with the terminals of the housing 204, 224 to form an electrically connection by a force exerted by an external clamp. The semiconductor device 202 described above has three terminals, however in some examples the semiconductor device may have fewer or more terminals, and it may be a thyristor, a GTO, an IEGT, an IGCT, a TRIAC, an IGBT, a MOSFET, a diode, or any other semiconductor device appropriate for the application.

The term cross sectional area, as used herein to refer to the dimensions of the terminals, refers to the cross sectional area of a section perpendicular to the flow of current.

Figure 2C is an embodiment of a semiconductor assembly 240 which comprises a housing 242 and multiple semiconductor devices 244a, 244b, 244c. In this example three semiconductor devices 244 are shown, however the semiconductor assembly 240 may comprise any number of devices. In this example the state change trigger terminal 246 is connected to each of the semiconductor devices 244 so that on application of an energy pulse to the state change trigger terminal 246, all the semiconductor devices 244 can be caused to permanently form a conductive path between their power terminals in the same manner as described above. Therefore if a semiconductor assembly 240 comprising a plurality of semiconductor devices comprises a single semiconductor device which has failed, an energy pulse may be applied to the state change trigger terminal causing the whole assembly to be 'shorted out' in a controlled manner.

In other examples, there may be a different number of semiconductor devices 244, which may differ in type, some or all of which may be connected to a common state change trigger terminal 246. In this example a gate terminal 248 of the housing is also shown, connecting to the gate terminals of each semiconductor device 244a, 244b, 244c.

An example of an apparatus which may include a press-pack package or an alternative semiconductor assembly such as those described in relation to Figures 2A, 2B and 2C is a Modular Multi-Level Converter (MMC).

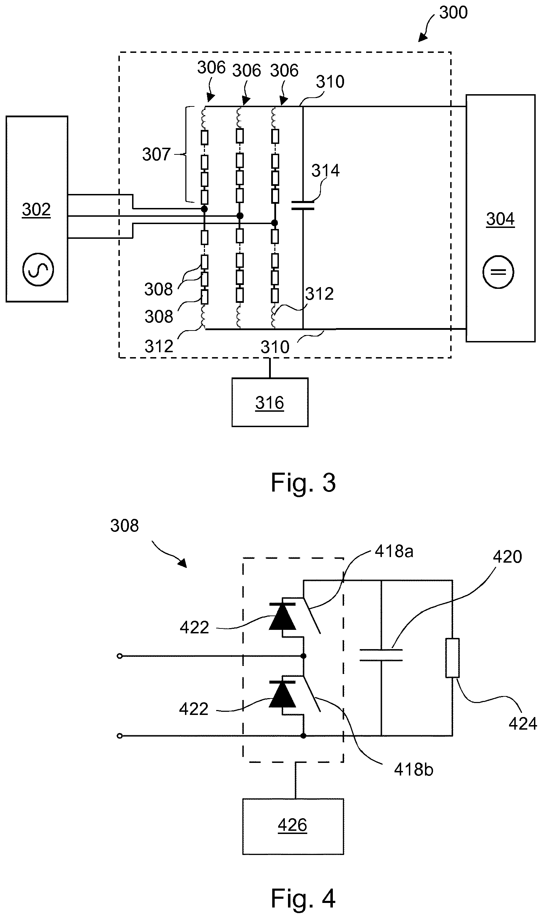

Figure 3 is an example of a Modular Multi-Level Converter (MMC) 300 arranged between an AC network 302 and a DC network 304. The MMC 300 includes respective phase limbs 306 (collectively forming a bridge) of series-connected converter submodules 308 (only some of which are labelled for the sake of clarity), arranged between DC poles 310. The submodules 308 are further described in relation to Figure 4 below.

Each limb 306 is made up of a first and a second (or top and bottom) valve 307 (only one of which is labelled for clarity). Therefore, as will also be familiar to the skilled person, such a converter 300 may be described as comprising six valves 307. The valves 307 comprise a series connection of submodules 308 between the AC connection to a limb 306 and a DC pole 310.

A valve reactor 312 (again, only two are labelled to avoid complicating the Figure) is also provided in each converter valve 307 to limit transient current flow between converter limbs 306 and thereby enable the connection and operation of the converter limbs 306. Also provided is an energy source, in this example a DC link capacitor 314, which operates to smooth the DC voltage. The converter 300 is under the control of converter control circuitry 316, which controls switching and monitoring functions. A 'broken line' notation is used in the limbs 306 to illustrate that there may be fewer or more submodules 308 provided than are illustrated.

As will be appreciated by the skilled person, a submodule 308 in this context is one of a number of such modules which are used to synthesise a voltage form in the converter 300 through selective switching of switches therein.

Figure 4 is an example of a prior art submodule. In this example, each converter submodule 308 comprises a pair of switches in the form of series-connected IGBTs 418 connected in parallel with a capacitor 420, each associated with a unidirectional current device, in this case a diode 422, arranged in anti-parallel with the IGBT switch 418. A first IGBT 418a is arranged between the terminals in series with the capacitor 420 and a second IGBT 418b is arranged to bypass the capacitor 420 when on. The capacitor 420 of each submodule 308 is configured to have a sufficiently high capacitive value in order to constrain the voltage variation at the capacitor terminals. The capacitor 420 is associated with a bleed resistance 424 to allow it to discharge when disconnected. A submodule controller 426 is also provided and is arranged to switch the IGBTs 418a, 418b. The submodule controller 426 may be arranged to implement autonomous protection strategies and responds to instructions from converter control circuitry 316.

The functioning of such a converter 300 will be familiar to the skilled person. Briefly, however, each submodule 308 as shown in Figure 3 may be controlled to assume different switching states in normal operation. The capacitor 420 is either inserted into the circuit or bypassed. More specifically, the capacitor 420 is inserted into the circuit when the first IGBT 418a is on and the second IGBT 418b is off, and it is bypassed when the first IGBT 418a is off and the second IGBT 418b is on. By controlling the IGBTs 418 in the submodules 308, voltage forms can be accurately synthesised.

As will be appreciated by the skilled person, the arrangement of Figure 4 is known as a half-bridge arrangement, and provides a 2-quadrant unipolar module that can provide zero or positive voltage and can conduct current in two directions. Although herein a half-bridge submodule design is described, this is purely by way of example and other submodule designs are possible, such as a full bridge arrangement (or full H bridge), in which submodules comprise two pairs of switching elements (usually IGBTs) and an energy storage device (usually in the form of a capacitor). The pairs of switching elements are connected in parallel with the capacitor. This defines a four-quadrant bipolar module that can provide negative, zero or positive voltage and can conduct current in two directions. Full bridge submodules give certain advantages, such as improved fault handing (in particular, improved DC fault handling), but require more switching components and have higher operational losses. As the skilled person will appreciate, other submodule designs are being developed, including multiple level submodules (for example as described in WO2014/005634, WO2012/04027 and US2008/0198630). Indeed, a converter may be a hybrid, containing more than one type of submodule 308. The principles set out herein could be applied to any submodule design as appropriate.

Further, the skilled person will be aware of alternative MMC designs, and the arrangement shown in Figures 3 and 4 is purely by way of an example of one such design. For example, the components, and/or the connections there between, may be configurable.

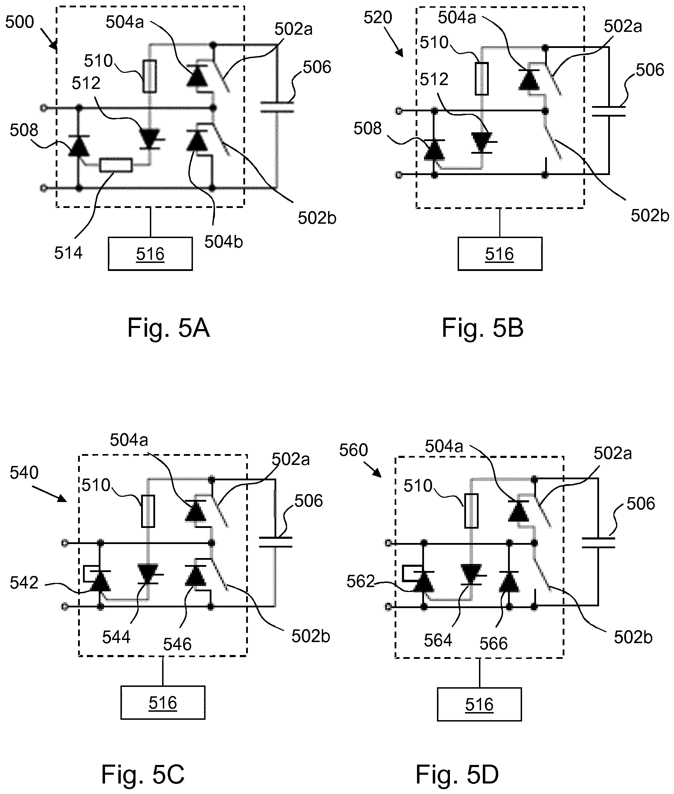

Figures 5A-E are examples of apparatus comprising semiconductor assemblies.

Figure 5A shows a first example of an MMC submodule 500. The MMC submodule 500 comprises IGBTs 502a and 502b, diodes 504a and 504b, and an energy source 506 which comprises a capacitor. These components are similar to those described in relation to Figure 4.

Additionally the submodule 500 comprises a semiconductor assembly 508, which is constructed in a manner similar to the semiconductor assembly as described above in Figures 2A or 2B, with the exception that the semiconductor device is a diode, rather than a switchable semiconductor device and therefore lacks a gate terminal. The semiconductor assembly 508 is connected in parallel with the IGBT 502b and the diode 504b and in series with IGBT 502a and diode 504a.

The submodule 500 also comprises a current interruption device, in this example an overcurrent protection element 510 and a control element 512. The control element 512 is connected in series with the overcurrent protection element 510 and is connected to the state change trigger terminal of the housing of the semiconductor assembly 508. The control element 512 may be any type of switch or switchable semiconductor device such as a transistor or thyristor. A current-limiting component, in this example a resistor 514, is fitted in series with the control element 512. This resistance in the energy delivery path reduces the peak current that might otherwise be required allowing overcurrent protection and control elements of lower rating to be employed and the use of smaller gauge interconnecting wiring.

The operation of the submodule 500 or the MMC is monitored to detect occurrence of a fault condition. If certain fault conditions are detected (such as failure of either IGBT to switch to the demanded state or excess pressure within the capacitor case), the control element 512 is switched by a controller 516 to connect the energy source 506 with the state change trigger terminal of the semiconductor assembly 508. Energy is delivered to the state change trigger terminal of the semiconductor assembly 508 which causes a permanent conductive path to form between the first and second power terminals of the semiconductor assembly 508. This energy is in the form of a brief pulse, which is interrupted by the action of the overcurrent protection element 510, as is described below.

If, for example, a fault is detected within the submodule 500, the semiconductor assembly 508 can thereby be permanently altered by the application of such energy to provide a short circuit across the submodule 500. However, the valve 307 in which the submodule 500 is arranged can continue to operate, provided the other submodules within the MMC 300 provide sufficient redundancy. The faulty submodule 500 may then be replaced or repaired at a later time and the interim operation of the MMC 300 is not interrupted.

As mentioned above, the submodule 500 also comprises an overcurrent protection element 510, such as a fuse or circuit breaker. The overcurrent protection element 510 is arranged in series with the control element 512. In the event of detection of a fault condition and switching of the control element 510, a current pulse will be delivered to the state change trigger terminal of the semiconductor assembly 508, through the control element 512 and the overcurrent protection element 510. In such an event the overcurrent protection element 510 will automatically form a break in the circuit shortly after the control element 512 is switched and current will cease to be delivered to the state change trigger terminal of the semiconductor assembly 508 shortly thereafter. This results in a short pulse of energy being delivered to the state change trigger terminal, which is quickly turned off by the overcurrent protection element 510 to prevent damage to other components within the circuit. In this way the energy 'pulse' is configured to deliver sufficient energy to alter the characteristics of the semiconductor assembly 508, but is stopped before further damage is caused to the submodule 500. The overcurrent protection element 510 may be characterised by its 'let-through energy', i.e. a measure of the amount of energy which will pass through the device before it turns off. The let-through energy of a device is given by I²t, where I is current and t is time. Controlling the amount of energy delivered by a pulse can be achieved by coordinating the let-through energy of the overcurrent protection element, with the let-through capability of the control element 512 and the energy that will cause the necessary damage to semiconductor assembly 508. Although conventionally referred to as 'let-through energy', the term does not describe a quantity of energy. The actual energy, E, is E=I²Rt, where R is the resistance of a device and E is the energy that causes the device to fail. When the time t is sufficiently short for the heating provided by the energy to be adiabatic, the 'let-through energy' is constant and therefore it is a convenient way to characterise a device.

Figure 5B shows an alternative submodule 520 which may be used in a MMC. Submodule 520 operates in a similar manner to submodule 500 in Figure 5A, however in this example the diode 504b is not present. Instead, the semiconductor assembly 508 acts as the diode, reducing the component count. Being a press-pack device, the semiconductor assembly 508 is able to survive fault currents that the diode 504b may not survive if the diode 504b is a wire-bond packaged device.

Both Figures 5A and 5B show submodules 500, 520 wherein the semiconductor assembly 508 is a diode. In these submodules 500, 520, the semiconductor assembly 508 therefore acts as a conductor to current in a first direction and an insulator in the opposing direction.

Figures 5C and 5D also show further examples of MMC submodules 540, 560. In these examples, semiconductor assemblies 542, 562 which comprise switchable semiconductor devices such as transistors or thyristors are provided. In these examples, the gate of the semiconductor device is connected to one of the power terminals in an arrangement similar to that shown in Figure 2B. This prevents the semiconductor device from switching and so the semiconductor assembly 542, 562 acts as an insulator, or a break, in the circuit to current flowing in either direction. As described previously, when a fault condition is detected, the control element 544, 564 is switched and an energy pulse is supplied to the state change trigger terminal of the semiconductor assembly 542, 562, permanently altering the semiconductor device to form a conductive path between its power terminals. The semiconductor assembly 542, 562 is then converted to a short circuit and the MMC can continue to operate after the failure of the submodule 540, 560.

Figures 5C and 5D also include a diode 546, 566 which is in anti-parallel with IGBT 502b. This diode 546, 566 may be located within the same package as IGBT 502b, as is shown in Figure 5C, or may be located external to the package of IGBT 502b as shown in Figure 5D. Locating the diode external to the package of IGBT 502b allows different technologies for the two to be used. For example, the IGBT may be wire bonded while the diode may be a press-pack, where the latter facilitates a surge current rating sufficient to survive fault currents.

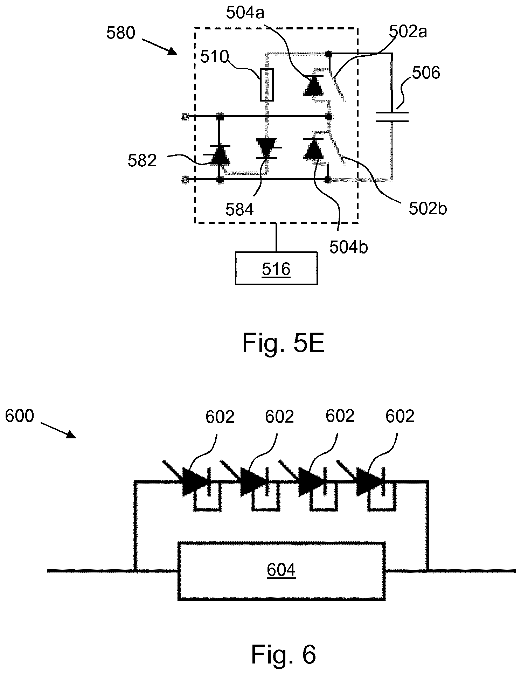

Figure 5E is a further example of a MMC submodule 580. In this example the semiconductor assembly 582 comprises a switchable semiconductor device, however the gate terminal of said device is not connected to one of the power terminals and is therefore similar to the semiconductor assembly described in relation to Figure 2A. This MMC submodule 580 operates in a similar manner to the MMC submodule 540 described in Figure 5C, however the semiconductor assembly 582 may be switched from conducting to an insulating state and from an insulating to a conducting state. For certain operating conditions (including fault conditions), it may be desirable to temporarily create a short circuit across the submodule 580, for example to divert current away from diode 504b where diode 504b is a wire-bond packaged device that cannot withstand the fault current. In such cases the semiconductor assembly 582 may be switched by applying a bias to the gate terminal of the semiconductor assembly 582. In other fault conditions, for example if the submodule 580 is determined to be permanently damaged, it may be desirable to create a permanent short circuit. In such events the control element 584 is operated, as described previously, to deliver an energy pulse to the state change trigger terminal of the housing of the semiconductor assembly 582 to permanently create a conductive electrical path between its power terminals.

Features of one submodule may be combined with those of another. For example,
figure 5A shows an optional resistor 514. A similar resistor may optionally be used in any of the circuits depicted in Figures 5A-5E depending on the requirements of the particular application.

Figure 6 is another example of an apparatus 600 comprising a semiconductor assembly 602. The apparatus 600 comprises multiple semiconductor assemblies 602 connected in series. In this example, the semiconductor assemblies 602 are similar to the semiconductor assembly 200 described previously in relation to Figure 2B. In parallel with the semiconductor assemblies 602 is circuit element 604, which in operation may fail, and on failure of the circuit element 604 it may be desirable to 'short out' the circuit element 604. In normal operation the semiconductor assemblies 602 are in a non-conductive state and all current flows through the circuit element 604. On detection of a failure of the circuit element 604, a pulse of energy is supplied to the semiconductor assemblies 602, causing a permanent conductive path to form between their power terminals, as described previously. An example of a circuit element 604 which may be used in this configuration is a static VAR (Volt Ampere Reactive) series compensator. This example shows four semiconductor assemblies 602, however in practice there may be fewer or more as is required by the particular application, and/or the semiconductor assemblies 602 may differ in form and/or be accompanied by a network of components to ensure that voltage is shared.

While the method, apparatus and related aspects of the invention have been described with reference to certain embodiments, various modifications, changes, omissions, and substitutions can be made.

It should be noted that the above-mentioned embodiments illustrate rather than limit what is described herein, and that those skilled in the art will be able to design many alternative implementations without departing from the scope of the appended claims. Features described in relation to one embodiment may be combined with features of another embodiment. The word "comprising" does not exclude the presence of elements other than those listed in a claim, "a" or "an" does not exclude a plurality, and a single processor or other unit may fulfil the functions of several units recited in the claims.

## Claims

1. A semiconductor assembly (200; 222; 240; 508; 542, 562; 582; 602) comprising:
a first power terminal (206; 212); a second power terminal (208; 214); a state change trigger terminal (216; 246); and a semiconductor device (202; 244) comprising a first terminal (206) and a second terminal (208);
wherein:
the first power terminal (206; 212) is electrically connected to the first terminal (206) of the semiconductor device (202; 244);
the second power terminal (208; 214) is electrically connected to the second terminal (208) of the semiconductor device (202; 244); and
the state change trigger terminal (216; 246) is connected to the second terminal (208) of the semiconductor device (202; 244) and is configured to deliver energy to the semiconductor device (202; 244) to cause a change in state thereof such that a permanent conductive path is formed between the first and second terminals (206; 208),
the semiconductor assembly being **characterized in that** the contact area of the connection of the state change trigger terminal (216; 246) with the second terminal (208) is smaller than the contact area of the first and second power terminals (212; 214) with the semiconductor device (202; 244).

2. A semiconductor assembly (200; 222; 240; 508; 542, 562; 582; 602) according to any preceding claim wherein the state change trigger terminal (216; 246) is capable of delivering an energy pulse with sufficient power density to cause the permanent conductive path to form between the first and second terminals (206; 208) of the semiconductor device (202; 244).

3. A semiconductor assembly (200; 222; 240; 508; 542, 562; 582; 602) according to any preceding claims wherein the semiconductor device (202; 244) comprises at least one of: a thyristor, a TRIAC, a GTO, an IGBT, an IEGT, an IGCT, a diode, a transistor or a MOSFET.

4. A semiconductor assembly (200; 222; 240; 508; 542, 562; 582; 602) according to any preceding claims wherein the semiconductor device (202; 244) comprises a third terminal (210), and said third terminal (210) is a gate terminal (210).

5. A semiconductor assembly (200; 222; 240; 508; 542, 562; 582; 602) according to claim 4 wherein the first terminal (206) of the semiconductor device (202; 244) is a cathode, emitter or source, and the second terminal (208) of the semiconductor device (202; 244) is an anode, collector or drain.

6. A semiconductor assembly (200; 222; 240; 508; 542, 562; 582; 602) according to claim 4 or claim 5 wherein the first terminal (206) of the semiconductor device (202; 244) and the gate terminal (210) of the semiconductor device (202; 244) are electrically connected via connections to the first power terminal (212).

7. A semiconductor assembly (200; 222; 240; 508; 542, 562; 582; 602) according to any of claims 4 to 6 comprising a gate terminal connection to connect to the gate terminal (210) of the semiconductor device (202; 244), wherein the state change trigger terminal (216; 246) has a larger cross sectional area than the gate terminal (210) connection, and the state change trigger terminal (216; 246) has a smaller cross sectional area than the power terminals (206; 208; 212; 214).

8. A semiconductor assembly (200; 222; 240; 508; 542, 562; 582; 602) according to any preceding claims comprising a housing (204; 224), the housing (204; 224) comprising the first power terminal (206; 212); the second power terminal (208; 214) and the state change trigger terminal (216; 246).

9. A semiconductor assembly (200; 222; 240; 508; 542, 562; 582; 602) according to claim 8 wherein the housing (204; 224) is a press-pack package or a flat pack package.

10. A semiconductor assembly (200; 222; 240; 508; 542, 562; 582; 602) according to any preceding claims wherein the semiconductor assembly (200; 222; 240; 508; 542, 562; 582; 602) comprises a plurality of semiconductor devices (244a, 244b, 244c) each comprising a first and second terminal (106; 108; 206; 208), and the state change trigger terminal (216; 246) is connected to at least two semiconductor devices (244a, 244b, 244c) and is configured to deliver energy to the connected semiconductor devices (244a, 244b, 244c) to cause a change in state of each connected semiconductor device (244a, 244b, 244c) such that a permanent conductive path is formed between the first and second terminals (106; 108; 206; 208) of the connected semiconductor devices.

11. Apparatus (500; 520; 540; 560; 580; 600) comprising:
a semiconductor assembly according to any one of claims 1 to 10;
an energy source (506); and
a controller (426; 516);
wherein the controller (426; 516) is configured to:
detect a fault condition, and on detection of said fault condition cause the energy source (506) to supply energy to the state change trigger terminal (216; 246) of the semiconductor assembly (200; 222; 240; 508; 542, 562; 582; 602) to trigger a state change in the semiconductor device (202; 244) to cause a permanent conductive path to form between a first power terminal (206; 212) and a second power terminal (208; 214) of the semiconductor device (202; 244).

12. Apparatus (500; 520; 540; 560; 580) according to claim 11 wherein the apparatus (500; 520; 540; 560; 580) is a Modular Multi-Level Converter (MMC) submodule and wherein the energy source (506) is an energy storage element which, in use of the submodule in an MMC, provides an energy source (506) for synthesising a voltage.

13. Apparatus (500; 520; 540; 560; 580; 600) according to any of claims 11 to 12 further comprising a control element configured to begin supply of energy to the state change trigger terminal (216; 246) of the semiconductor assembly (200; 222; 240; 508; 542, 562; 582; 602) and a current interruption device (510; 512) configured to end supply of energy to the state change trigger terminal (216; 246) of the semiconductor assembly (200; 222; 240; 508; 542, 562; 582; 602), wherein
the controller (426; 516) is configured to switch the control element to begin supply of energy; and
the current interruption device (510; 512) is configured to interrupt the supply of energy once a pulse energy capable of causing the permanent conductive path to form has been delivered to the state change trigger terminal (216; 246).

14. A method of operating a semiconductor assembly (200; 222; 240; 508; 542, 562; 582; 602) within the apparatus (500; 520; 540; 560; 580; 600) according to any one of claims 11 to 13 comprising:
monitoring operation of the apparatus (500; 520; 540; 560; 580; 600) to detect a fault condition;
and, on detection of a fault condition;
delivering energy to a semiconductor material within the semiconductor assembly (200; 222; 240; 508; 542, 562; 582; 602) to cause a permanent conductive path to form through the semiconductor material.

15. A method according to claim 14 wherein the energy is delivered by a pulse of current to heat the semiconductor material to cause a breakdown in the structure of the semiconductor material.

## Patentansprüche

1. Halbleiteranordnung (200; 222; 240; 508; 542, 562; 582; 602), umfassend:
einen ersten Leistungsanschluss (206; 212); einen zweiten Leistungsanschluss (208; 214); einen Zustandsänderungs-Triggeranschluss (216; 246); und ein Halbleiterbauelement (202; 244), das einen ersten Anschluss (206) und einen zweiten Anschluss (208) umfasst;
wobei:
der erste Leistungsanschluss (206; 212) elektrisch mit dem ersten Anschluss (206) des Halbleiterbauelements (202; 244) verbunden ist;
der zweite Leistungsanschluss (208; 214) elektrisch mit dem zweiten Anschluss (208) des Halbleiterbauelements (202; 244) verbunden ist; und
der Zustandsänderungs-Triggeranschluss (216; 246) mit dem zweiten Anschluss (208) des Halbleiterbauelements (202; 244) verbunden ist und dazu ausgebildet ist, Energie an das Halbleiterbauelement (202; 244) zu liefern, um eine Änderung des Zustands desselben derart zu bewirken, dass zwischen dem ersten und zweiten Anschluss (206; 208) ein dauerhafter leitender Pfad gebildet wird,
wobei die Halbleiteranordnung **dadurch gekennzeichnet ist, dass** die Kontaktfläche der Verbindung des Zustandsänderungs-Triggeranschlusses (216; 246) mit dem zweiten Anschluss (208) kleiner ist als die Kontaktfläche des ersten und zweiten Leistungsanschlusses (212; 214) mit dem Halbleiterbauelement (202; 244).

2. Halbleiteranordnung (200; 222; 240; 508; 542, 562; 582; 602) nach einem vorstehenden Anspruch, wobei der Zustandsänderungs-Triggeranschluss (216; 246) in der Lage ist, einen Energieimpuls mit ausreichender Leistungsdichte zu liefern, um zu bewirken, dass der dauerhaft leitende Pfad zwischen dem ersten und zweiten Anschluss (206; 208) des Halbleiterbauelements (202; 244) gebildet wird.

3. Halbleiteranordnung (200; 222; 240; 508; 542, 562; 582; 602) nach einem der vorstehenden Ansprüche, wobei das Halbleiterbauelement (202; 244) mindestens eines umfasst aus: einem Thyristor, einem TRIAC, einem GTO, einem IGBT, einem IEGT, einem IGCT, einer Diode, einem Transistor oder einem MOSFET.

4. Halbleiteranordnung (200; 222; 240; 508; 542, 562; 582; 602) nach einem der vorstehenden Ansprüche, wobei das Halbleiterbauelement (202; 244) einen dritten Anschluss (210) umfasst, und der dritte Anschluss (210) ein Gate-Anschluss (210) ist.

5. Halbleiteranordnung (200; 222; 240; 508; 542, 562; 582; 602) nach Anspruch 4, wobei der erste Anschluss (206) des Halbleiterbauelements (202; 244) eine Kathode, ein Emitter oder eine Quelle ist, und der zweite Anschluss (208) des Halbleiterbauelements (202; 244) eine Anode, ein Kollektor oder eine Senke ist.

6. Halbleiteranordnung (200; 222; 240; 508; 542, 562; 582; 602) nach Anspruch 4 oder Anspruch 5, wobei der erste Anschluss (206) des Halbleiterbauelements (202; 244) und der Gate-Anschluss (210) des Halbleiterbauelements (202; 244) über Verbindungen elektrisch mit dem ersten Leistungsanschluss (212) verbunden sind.

7. Halbleiteranordnung (200; 222; 240; 508; 542, 562; 582; 602) nach einem der Ansprüche 4 bis 6, die eine Gate-Anschlussverbindung umfasst, um mit dem Gate-Anschluss (210) des Halbleiterbauelements (202; 244) zu verbinden, wobei der Zustandsänderungs-Triggeranschluss (216; 246) eine größere Querschnittsfläche als die Gate-Anschlussverbindung (210) aufweist, und der Zustandsänderungs-Triggeranschluss (216; 246) eine kleinere Querschnittsfläche als die Leistungsanschlüsse (206; 208; 212; 214) aufweist.

8. Halbleiteranordnung (200; 222; 240; 508; 542, 562; 582; 602) nach einem der vorstehenden Ansprüche, die ein Gehäuse (204; 224) umfasst, wobei das Gehäuse (204; 224) den ersten Leistungsanschluss (206; 212); den zweiten Leistungsanschluss (208; 214) und den Zustandsänderungs-Triggeranschluss (216; 246) umfasst.

9. Halbleiteranordnung (200; 222; 240; 508; 542, 562; 582; 602) nach Anspruch 8, wobei das Gehäuse (204; 224) ein Press-Pack-Paket oder ein Flat-Pack-Paket ist.

10. Halbleiteranordnung (200; 222; 240; 508; 542, 562; 582; 602) nach einem der vorstehenden Ansprüche, wobei die Halbleiteranordnung (200; 222; 240; 508; 542, 562; 582; 602) eine Vielzahl von Halbleiterbauelementen (244a, 244b, 244c) umfasst, die jedes einen ersten und zweiten Anschluss (106; 108; 206; 208) umfassen, und der Zustandsänderungs-Triggeranschluss (216; 246) mit mindestens zwei Halbleiterbauelementen (244a, 244b, 244c) verbunden ist und dazu ausgebildet ist, Energie an die verbundenen Halbleiterbauelemente (244a, 244b, 244c) zu liefern, um eine Änderung des Zustands jedes verbundenen Halbleiterbauelements (244a, 244b, 244c) derart zu bewirken, dass zwischen dem ersten und zweiten Anschluss (106; 108; 206; 208) der verbundenen Halbleiterbauelemente ein dauerhafter leitender Pfad gebildet wird.

11. Vorrichtung (500; 520; 540; 560; 580; 600), umfassend:
eine Halbleiteranordnung nach einem der Ansprüche 1 bis 10;
eine Energiequelle (506); und
eine Steuerung (426; 516);
wobei die Steuerung (426; 516) dazu ausgebildet ist:
eine Fehlerbedingung zu erkennen und bei Erkennen der Fehlerbedingung zu bewirken, dass die Energiequelle (506) dem Zustandsänderungs-Triggeranschluss (216; 246) der Halbleiteranordnung (200; 222; 240; 508; 542, 562; 582; 602) Energie zuführt, um eine Änderung des Zustands des Halbleiterbauelements (202; 244) auszulösen, um zu bewirken, dass zwischen einem ersten Leistungsanschluss (206; 212) und einem zweiten Leistungsanschluss (208; 214) des Halbleiterbauelements (202; 244) ein dauerhaft leitender Pfad gebildet wird.

12. Vorrichtung (500; 520; 540; 560; 580) nach Anspruch 11, wobei die Vorrichtung (500; 520; 540; 560; 580) ein Modular Multi-Level Converter- (MMC) Submodul ist, und wobei die Energiequelle (506) ein Energiespeicherelement ist, das bei Verwendung des Submoduls in einem MMC eine Energiequelle (506) zum Erzeugen einer Spannung bereitstellt.

13. Vorrichtung (500; 520; 540; 560; 580; 600) nach einem der Ansprüche 11 bis 12, die weiter ein Steuerelement umfasst, das dazu ausgebildet ist, Zuführung von Energie an den Zustandsänderungs-Triggeranschluss (216; 246) der Halbleiteranordnung (200; 222; 240; 508; 542, 562; 582; 602) zu starten, und ein Stromunterbrechungsbauelement (510; 512), das dazu ausgebildet ist, Zuführung von Energie an den Zustandsänderungs-Triggeranschluss (216; 246) der Halbleiteranordnung (200; 222; 240; 508; 542, 562; 582; 602) zu stoppen, wobei
die Steuerung (426; 516) dazu ausgebildet ist, das Steuerelement zu schalten, um Zuführung von Energie zu starten; und
das Stromunterbrechungsbauelement (510; 512) dazu ausgebildet ist, die Zuführung von Energie zu unterbrechen, sobald eine Impulsenergie, die in der Lage ist zu bewirken, dass der dauerhaft leitende Pfad gebildet wird, an den Zustandsänderungs-Triggeranschluss (216; 246) geliefert wurde.

14. Verfahren zum Betreiben einer Halbleiteranordnung (200; 222; 240; 508; 542, 562; 582; 602) in der Vorrichtung (500; 520; 540; 560; 580; 600) nach einem der Ansprüche 11 bis 13, umfassend:
Überwachen des Betriebs der Vorrichtung (500; 520; 540; 560; 580; 600), um eine Fehlerbedingung zu erkennen;
und bei Erkennen einer Fehlerbedingung;
Liefern von Energie an ein Halbleitermaterial in der Halbleiteranordnung (200; 222; 240; 508; 542, 562; 582; 602), um zu bewirken, dass ein dauerhaft leitender Pfad durch das Halbleitermaterial gebildet wird.

15. Verfahren nach Anspruch 14, wobei die Energie durch einen Stromimpuls geliefert wird, um das Halbleitermaterial zu erwärmen, um einen Durchbruch in der Struktur des Halbleitermaterials zu bewirken.

## Revendications

1. Ensemble semi-conducteur (200 ; 222 ; 240 ; 508 ; 542, 562 ; 582 ; 602) comprenant :
une première borne d'alimentation (206 ; 212) ; une deuxième borne d'alimentation (208; 214) ; une borne de déclenchement de changement d'état (216; 246) ; et un dispositif semi-conducteur (202 ; 244) comprenant une première borne (206) et une deuxième borne (208);
dans lequel :
la première borne d'alimentation (206; 212) est électriquement connectée à la première borne (206) du dispositif semi-conducteur (202 ; 244) ;
la deuxième borne d'alimentation (208 ; 214) est électriquement connectée à la deuxième borne (208) du dispositif semi-conducteur (202 ; 244) ; et
la borne de déclenchement de changement d'état (216 ; 246) est connectée à la deuxième borne (208) du dispositif semi-conducteur (202; 244) et est configurée pour délivrer de l'énergie au dispositif semi-conducteur (202; 244) pour provoquer un changement d'état de celui-ci de telle sorte qu'un trajet conducteur permanent est formé entre les première et deuxième bornes (206 ; 208),
l'ensemble semi-conducteur étant **caractérisé en ce que** la superficie de contact de la connexion de la borne de déclenchement de changement d'état (216 ; 246) avec la deuxième borne (208) est plus petite que la superficie de contact des première et deuxième bornes d'alimentation (212 ; 214) avec le dispositif semi-conducteur (202 ; 244).

2. Ensemble semi-conducteur (200 ; 222 ; 240; 508; 542, 562 ; 582 ; 602) selon une quelconque revendication précédente dans lequel la borne de déclenchement de changement d'état (216; 246) est capable de délivrer une impulsion d'énergie avec une densité de puissance suffisante pour amener le trajet conducteur permanent à se former entre les première et deuxième bornes (206; 208) du dispositif semi-conducteur (202 ; 244).

3. Ensemble semi-conducteur (200 ; 222 ; 240 ; 508; 542, 562 ; 582 ; 602) selon une quelconque revendication précédente dans lequel le dispositif semi-conducteur (202 ; 244) comprend au moins l'un parmi : un thyristor, un TRIAC, un GTO, un IGBT, un IEGT, un IGCT, une diode, un transistor ou un MOSFET.

4. Ensemble semi-conducteur (200 ; 222 ; 240; 508; 542, 562 ; 582 ; 602) selon une quelconque revendication précédente dans lequel le dispositif semi-conducteur (202 ; 244) comprend une troisième borne (210), et ladite troisième borne (210) est une borne de grille (210).

5. Ensemble semi-conducteur (200; 222 ; 240 ; 508; 542, 562 ; 582; 602) selon la revendication 4 dans lequel la première borne (206) du dispositif semi-conducteur (202 ; 244) est une cathode, un émetteur ou une source, et la deuxième borne (208) du dispositif semi-conducteur (202 ; 244) est une anode, un collecteur ou un drain.

6. Ensemble semi-conducteur (200; 222 ; 240; 508; 542, 562; 582; 602) selon la revendication 4 ou la revendication 5 dans lequel la première borne (206) du dispositif semi-conducteur (202 ; 244) et la borne de grille (210) du dispositif semi-conducteur (202; 244) sont électriquement connectées via des connexions à la première borne d'alimentation (212).

7. Ensemble semi-conducteur (200 ; 222 ; 240 ; 508 ; 542, 562 ; 582 ; 602) selon l'une quelconque des revendications 4 à 6 comprenant une connexion de borne de grille pour se connecter à la borne de grille (210) du dispositif semi-conducteur (202 ; 244), dans lequel la borne de déclenchement de changement d'état (216; 246) présente une superficie transversale plus grande que la connexion de borne de grille (210), et la borne de déclenchement de changement d'état (216; 246) présente une superficie transversale plus petite que les bornes d'alimentation (206; 208 ; 212 ; 214).

8. Ensemble semi-conducteur (200 ; 222 ; 240; 508; 542, 562 ; 582 ; 602) selon une quelconque revendication précédente comprenant un logement (204 ; 224), le logement (204 ; 224) comprenant la première borne d'alimentation (206; 212) ; la deuxième borne d'alimentation (208 ; 214) et la borne de déclenchement de changement d'état (216 ; 246).

9. Ensemble semi-conducteur (200; 222 ; 240; 508; 542, 562; 582; 602) selon la revendication 8 dans lequel le logement (204 ; 224) est un paquet pressé ou un paquet plat.

10. Ensemble semi-conducteur (200 ; 222 ; 240 ; 508; 542, 562 ; 582; 602) selon une quelconque revendication précédente dans lequel l'ensemble semi-conducteur (200 ; 222 ; 240 ; 508 ; 542, 562 ; 582 ; 602) comprend une pluralité de dispositifs semi-conducteurs (244a, 244b, 244c) comprenant chacun une première et une deuxième borne (106 ; 108 ; 206 ; 208), et la borne de déclenchement de changement d'état (216 ; 246) est connectée à au moins deux dispositifs semi-conducteurs (244a, 244b, 244c) et est configurée pour délivrer de l'énergie aux dispositifs semi-conducteurs (244a, 244b, 244c) connectés pour provoquer un changement d'état de chaque dispositif semi-conducteur (244a, 244b, 244c) connecté de telle sorte qu'un trajet conducteur permanent est formé entre les première et deuxième bornes (106 ; 108 ; 206 ; 208) des dispositifs semi-conducteurs connectés.

11. Appareil (500 ; 520 ; 540 ; 560 ; 580 ; 600) comprenant :
un ensemble semi-conducteur selon l'une quelconque des revendications 1 à 10 ;
une source d'énergie (506) ; et
un dispositif de commande (426 ; 516) ;
dans lequel le dispositif de commande (426 ; 516) est configuré pour :
détecter une condition de défaillance, et lors de la détection de ladite condition de défaillance amener la source d'énergie (506) à apporter de l'énergie à la borne de déclenchement de changement d'état (216 ; 246) de l'ensemble semi-conducteur (200 ; 222 ; 240; 508 ; 542, 562; 582; 602) pour déclencher un changement d'état dans le dispositif semi-conducteur (202 ; 244) afin d'amener un trajet conducteur permanent à se former entre une première borne d'alimentation (206; 212) et une deuxième borne d'alimentation (208 ; 214) du dispositif semi-conducteur (202 ; 244).

12. Appareil (500 ; 520; 540; 560; 580) selon la revendication 11 dans lequel l'appareil (500 ; 520 ; 540 ; 560 ; 580) est un sous-module de convertisseur modulaire multi-niveau (MMC) et dans lequel la source d'énergie (506) est un élément de stockage d'énergie qui, lors de l'utilisation du sous-module dans un MMC, fournit une source d'énergie (506) pour synthétiser une tension.

13. Appareil (500 ; 520 ; 540 ; 560 ; 580 ; 600) selon l'une quelconque des revendications 11 à 12 comprenant en outre un élément de commande configuré pour commencer l'apport d'énergie à la borne de déclenchement de changement d'état (216 ; 246) de l'ensemble semi-conducteur (200 ; 222 ; 240; 508; 542, 562 ; 582 ; 602) et un dispositif d'interruption de courant (510 ; 512) configuré pour cesser l'apport d'énergie à la borne de déclenchement de changement d'état (216 ; 246) de l'ensemble semi-conducteur (200 ; 222 ; 240 ; 508 ; 542, 562 ; 582 ; 602), dans lequel
le dispositif de commande (426 ; 516) est configuré pour commuter l'élément de commande pour commencer l'apport d'énergie ; et
le dispositif d'interruption de courant (510 ; 512) est configuré pour interrompre l'apport d'énergie une fois qu'une énergie d'impulsion capable de provoquer la formation du trajet conducteur permanent a été délivrée à la borne de déclenchement de changement d'état (216 ; 246).

14. Procédé de fonctionnement d'un ensemble semi-conducteur (200 ; 222 ; 240 ; 508; 542, 562; 582; 602) dans l'appareil (500 ; 520 ; 540 ; 560 ; 580 ; 600) selon l'une quelconque des revendications 11 à 13 comprenant :
la surveillance du fonctionnement de l'appareil (500 ; 520 ; 540 ; 560 ; 580 ; 600) pour détecter une condition de défaillance ;
et, lors de la détection d'une condition de défaillance ;
la délivrance d'énergie à un matériau semi-conducteur dans l'ensemble semi-conducteur (200; 222 ; 240; 508; 542, 562; 582; 602) pour provoquer la formation d'un trajet conducteur permanent à travers le matériau conducteur.

15. Procédé selon la revendication 14 dans lequel l'énergie est délivrée par une impulsion de courant pour chauffer le matériau conducteur afin de provoquer une panne dans la structure du matériau semi-conducteur.
